(19)

Europäisches
Patentamt
European
Patent Office
Office européen
des brevets

(11)  EP 2 355 646 A2

(12)  **EUROPEAN PATENT APPLICATION**

(43) Date of publication:
   **10.08.2011  Bulletin 2011/32**

(51) Int Cl.:
   *H05K 13/04* (2006.01)   *H05K 13/08* (2006.01)

(21) Application number: **11000680.6**

(22) Date of filing: **27.01.2011**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(30) Priority: **29.01.2010  JP 2010018455**

(71) Applicant: **Hitachi High-Tech Instruments Co., Ltd.
   Kumagaya-shi
   Saitama 360-0238 (JP)**

(72) Inventors:
   • **Asakura, Ryoji
     Tokyo 100-8220 (JP)**
   • **Tamaki, Kenji
     Tokyo 100-8220 (JP)**
   • **Hoshino, Masahiro
     Kumagaya-shi
     Saitama 360-0238 (JP)**
   • **Moriya, Yuji
     Kumagaya-shi
     Saitama 360-0238 (JP)**

(74) Representative: **Strehl Schübel-Hopf & Partner
   Maximilianstrasse 54
   80538 München (DE)**

(54)   **Component mounting apparatus with abnormality detecting device**

(57)   A technique in which a cause of an abnormality is presented when the abnormality occurs in a component mounting apparatus is provided. An arithmetic device creates a function of outputting a real value for each cause candidate of the abnormality with inputting the apparatus information by using apparatus information for specifying a frequency at which mounting of a component by a component mounting apparatus fails at least at a time when the abnormality occurs, and cause information for specifying the cause of the abnormality. When the abnormality newly occurs, the arithmetic device outputs the real value for each cause candidate of the abnormality by using a frequency at which mounting of the component by the component mounting apparatus fails at a time when the abnormality newly occurs, and the function, and presents the cause candidate largest in the real value as the cause of the abnormality.

FIG. 1

EP 2 355 646 A2

**Description**

TECHNICAL FIELD

The present invention relates to a component mounting apparatus that mounts a component such as a chip mounter on a board, and more particularly to a component mounting apparatus with an abnormality detecting device which detects an abnormality occurring when a component is mounted on a board, and presents a cause of the abnormality.

BACKGROUND ART

In the component mounting device that mounts an electronic component on a circuit board, a component held by a feeder of a component feed device is sucked by a suction nozzle of a mounting head, conveyed to a given position of the circuit board, and mounted thereon.

In such a component mounting device, there may occur such an abnormality that the suction nozzle cannot suck the component from the feeder.

When the above abnormality occurs, the operation of the component mounting apparatus must be stopped until the cause of abnormality is specified, and the specified cause of abnormality is removed, thereby deteriorating the production capacity of the component mounting apparatus. Accordingly, there is a need to quickly specify the above-mentioned cause of abnormality, and implement a measure of the cause.

Japanese Patent Laid-open No. 2005-327909(Japanese Patent Application No. 2004-144775) discloses a technique for extracting a factor causing the abnormality from information indicative of the contents of implemented maintenance, information indicative of the contents of trouble occurring in the component mounting apparatus, and information indicative of the contents of the measure implemented to restore the component mounting apparatus when an abnormality occurs in the circuit board, to determine a measure for eliminating the factor.

DISCLOSURE OF THE INVENTION

In the technique disclosed in Japanese Patent Laid-open No. 2005-327909, a correspondence relationship between data recorded in the apparatus and the causes of abnormality is defined in advance, and the cause of abnormality is estimated from the data recorded in the apparatus by using the correspondence relationship when the abnormality occurs.

The cause of abnormality occurring in the apparatus changes depending on environment in which the apparatus is installed. For example, the suction nozzle is frequently clogged in the environments where there are many dusts. In the technique disclosed in Japanese Patent Laid-open No. 2005-327909, the correspondence relationship cannot be corrected to fit the environments where the apparatus is installed. For that reason, there is a case in which another abnormality is estimated as a cause, for example, even in the environment where the suction nozzle is frequently clogged. In this case, it takes much time to analyze the cause of the abnormality. Then, because the component mounting apparatus is stopping while the cause of abnormality is analyzed, the production capacity of the component mounting apparatus is deteriorated in this case.

Therefore, an object of the present invention is to provide a component mounting apparatus with an abnormality detecting device which can correct a correspondence relationship between data recorded in the apparatus and a cause of abnormality so as to fit the circumstances, and estimate the cause of the abnormality by using the corrected correspondence relationship.

In order to address the above problems, according to the present invention, with the use of data indicative of a condition of the apparatus when an abnormality occurs and data indicative of the cause of the abnormality, a mathematic expression representative of the correspondence relationship between data indicative of the condition of the apparatus when the abnormality occurs and the cause of the abnormality is corrected to correct the cause of the abnormality which is estimated when the abnormality occurs to fit the environments in which the apparatus is installed.

For example, there are provided a storage part that stores therein apparatus information for specifying a value resulting from dividing an abnormality frequency ratio at a time when the abnormality occurs in the suction nozzle by an abnormality frequency ratio at a time when the abnormality occurs in a feeder, cause information for specifying the cause of the abnormality, and coefficient information for specifying a coefficient of a mathematic expression that inputs a value of the apparatus information and outputs a numerical value for each cause candidate of the abnormality, and a control part. The control part conducts, when update of the coefficient information is instructed, a process of converting the cause information into a real number, and a process of determining the coefficient of the mathematical expression so that a difference between the real number and a value output by inputting the value of the apparatus information to the mathematical expression becomes smallest, and storing the determined coefficient in the coefficient information. The control part also conducts, when the abnormality occurs, a process of inputting a value resulting from dividing the abnormality frequency ratio at the time when the abnormality occurs in the suction nozzle by the abnormality frequency ratio at the time when the abnormality occurs in the feeder, and outputting a numerical value for each cause candidate of the abnormality by using the mathematic expression, with the value stored in the coefficient information as the coefficient, and a process of outputting the largest numerical value for the cause candidate as the cause of the abnormality.

According to the present invention, the cause of the abnormality estimated at the time when the abnormality occurs can be corrected to fit the environments in which the apparatus is installed.

BRIEF DESCRIPTION OF THE DRAWINGS

FIG. 1 is a diagram illustrating the configuration of a component mounting apparatus according to the present invention;

FIG. 2 is a top view illustrating a feeder base, a head, a beam, and a board;

FIG. 3 is a bottom view illustrating the head;

FIG. 4 is a schematic view showing an example of an apparatus information table;

FIG. 5 is a schematic view showing an example of the apparatus information table;

FIG. 6 is a diagram illustrating the configuration of an arithmetic device;

FIG. 7 is a schematic view showing an example of an abnormality history information table;

FIG. 8 is a schematic view showing an example of an apparatus operation information table;

FIG. 9 is a schematic view showing an example of an abnormality frequency information table;

FIG. 10 is a schematic view showing an example of an abnormality frequency ratio information table;

FIG. 11 is a schematic view showing an example of a feeder abnormality frequency information table;

FIG. 12 is a schematic view showing an example of an estimated result information table;

FIG. 13 is a schematic view showing an example of a coefficient information table;

FIG. 14 is a schematic view showing an example of a learning information table;

FIG. 15 is a flowchart showing processing that is executed by the arithmetic device when an abnormality occurs;

FIG. 16 is a flowchart showing processing that is executed by the arithmetic device upon receiving an instruction for estimating a cause of the abnormality;

FIG. 17 is a diagram illustrating an example of an image that is displayed after the cause of the abnormality has been estimated;

FIG. 18 is a flowchart showing processing that is executed by the arithmetic device upon receiving an instruction for learning processing;

FIG. 19 is a diagram illustrating an example of an image that is displayed at the time of inputting a learning instruction;

FIG. 20 is a graph showing the results of the learning processing; and

FIG. 21 is a diagram illustrating an example of a computer that configures the arithmetic device according to this embodiment.

BEST MODE FOR CARRYING OUT THE INVENTION

Hereinafter, embodiments of the present invention will be described with reference to the accompanying drawings.

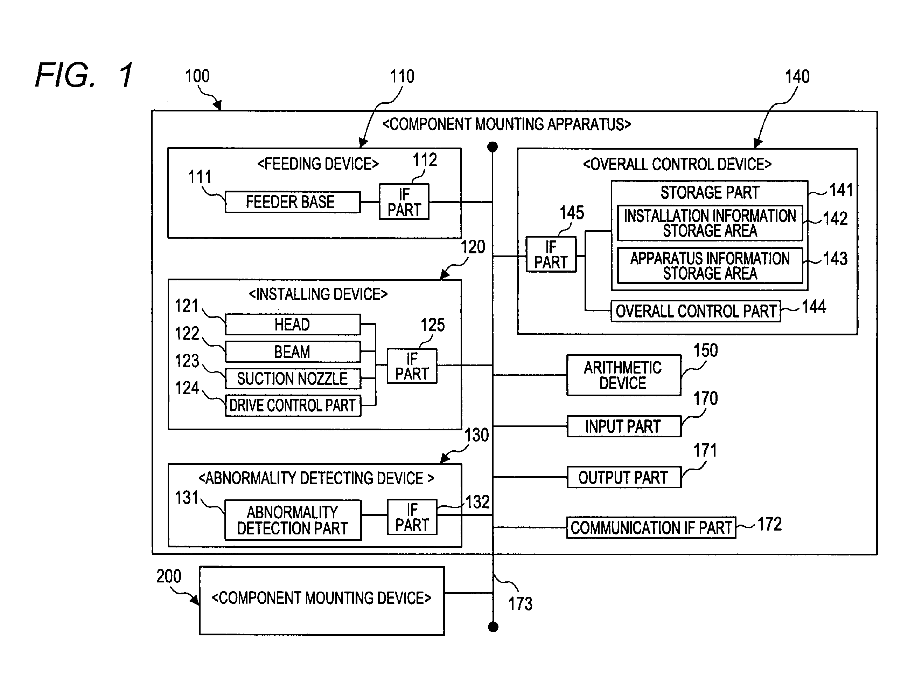

FIG. 1 is a schematic diagram illustrating a component mounting apparatus 100 according to an embodiment of the present invention. As illustrated in FIG. 1, a component mounting apparatus 100 includes a feeding device 110, an installing device 120, an abnormality detecting device 130, an overall control device 140, an arithmetic device 150, an input part 170, an output part 171, and a communication IF part 172. Those elements are mutually connected through a bus 173.

Also, the component mounting apparatus 100 is mutually connected through the bus 173 to another component mounting apparatus 200 having a feeding device, an installing device, an abnormality detecting device, an overall control device, an arithmetic device, an input part, an output part, a communication IF part, and a bus as in the component mounting apparatus 100.

In FIG. 1, the arithmetic device 150 is disposed within each of the component mounting apparatuses 100 and 200. Alternatively, the arithmetic device 150 can be disposed within a personal computer located outside the component mounting apparatuses through a communication channel such as a LAN. In this case, the whole of the arithmetic device 150 can be disposed outside the component mounting apparatus, or a part of the arithmetic device 150 can be disposed outside the component mounting apparatus.

Hereinafter, each of the feeding device, the installing device, the abnormality detecting device, the overall control device, the arithmetic device, the input part, the output part, and the communication IF part as described above will be described in detail.

(Feeding Device)

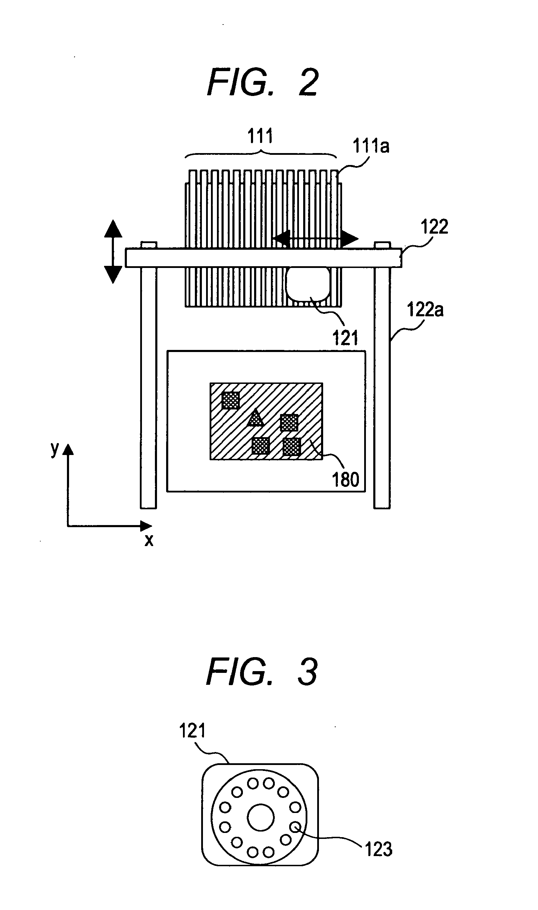

The feeding device 110 includes a feeder base 111 and an IF part 112. FIG. 2 illustrates a schematic diagram of the feeder base 111, a head 121, and a beam 122. Plural feeders 111a are disposed in the feeder base 111. When components held by the feeders 111a are sucked by suction nozzles 123 that will be described later according to an instruction of the overall control device 140, the feeders 111a convey the remaining held components to a position where the components can be sucked by the suction nozzles 123.
Also, the IF part 112 is an interface for transmitting and receiving information through the bus 173.

(Installing Device)

The installing device 120 includes the head 121, the beam 122, the suction nozzles 123, and a drive control part 124, and an IF part 125.
The head 121 can travel along the beam 122 in one axial direction of coordinates (X-direction in FIG. 2) as illustrated in FIG. 2.
The beam 122 can travel along guides 122a in another axial direction of the coordinates (Y-direction in FIG. 2) which are orthogonal to one axial direction of the coordinates in which the head 121 travels, as illustrated in FIG. 2.
The head 121 and the beam 122 are made to travel in the X-direction and the Y-direction so that a component can be sucked out of any feeder 111a mounted on the feeder base 111, and installed at a given position of a board 180, by a given suction nozzle 123.
The drive control part 124 controls the head 121, the beam 122, and the suction nozzles 123 to install the component at an installation position and in an installation order, which are specified by an installation information table 142a that will be described later, according to an instruction from the overall control device 140 that will be described later. Also, when the drive control part 124 controls each suction nozzle 123 to suck the component, the drive control part 124 conducts a process of transmitting suction information indicating that the component has been sucked, to the overall control device 140 through the IF part 125.
The IF part 125 is an interface for transmitting and receiving the information through the bus 173.

(Abnormality Detecting Device)

The abnormality detecting device 130 includes an abnormality detecting part 131 and an IF part 132.
The abnormality detecting part 131 determines whether there is a suction abnormality of the component by the suction nozzle 123, or not, upon receiving an instruction for determination of an abnormality from the overall control device 140. For example, the abnormality detecting part 131 images the position, configuration, and posture of the component sucked to the suction nozzle 123, and determines whether there is an abnormality in the position, configuration, and posture, or not, in a pattern matching manner.
When the abnormality detecting part 131 determines that there is the suction abnormality in the component, the abnormality detecting part 131 outputs, to the overall control device 140, abnormality occurrence information for specifying the occurrence of the abnormality.
The IF part 132 is an interface for transmitting and receiving the information through the bus 173.

(Overall Control Device)

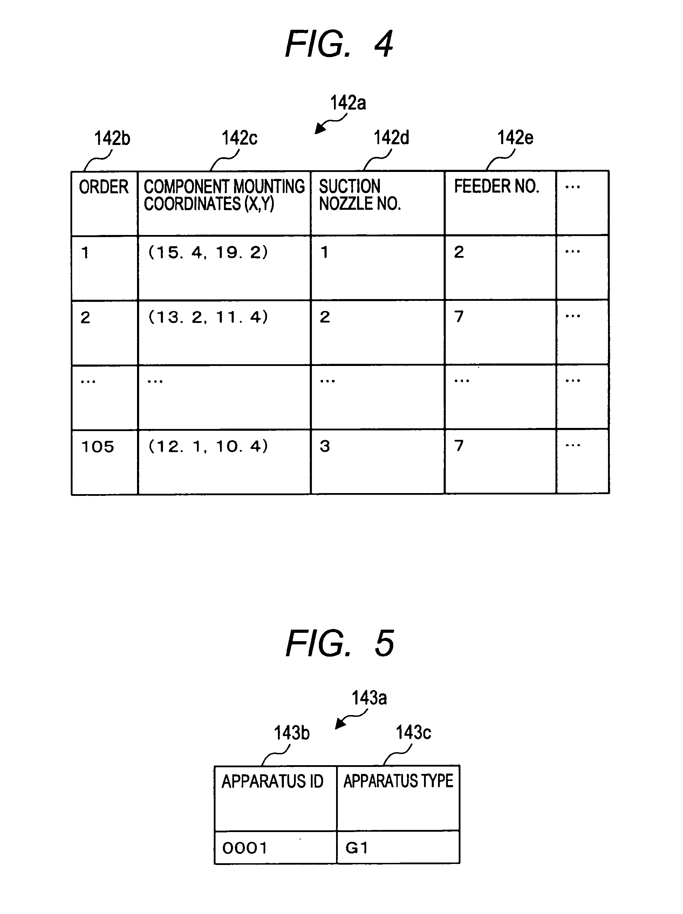

The overall control device 140 includes a storage part 141, an overall control part 144, and an IF part 145.
The storage part 141 includes an installation information storage area 142 and an apparatus information storage area 143.
First, in the installation information storage area 142 is stored installation information for specifying an installation order and a suction order of the components, a position at which each component is installed on the board, a position of each suction nozzle 123 that sucks the component, and a position of each feeder 111a that feeds the component. For example, in this embodiment, the installation information table 142a shown in FIG. 4 is stored in the installation information storage area 142.
As shown in FIG. 4, the installation information table 142a includes an order field 142b, a component installation coordinate field 142c, a suction nozzle No. field 142d, and a feeder No. field 142e.
In the order field 142b is stored information for specifying the installation order of the components and the suction order of the components. In this embodiment, the installation order and the suction order of the components are the same, but those orders may be different from each other.

In the component installation coordinate field 142c is stored information for specifying a position at which the component of a type, which is sucked from a position where the feeder 111a specified by the feeder No. field 142e is mounted in the feeder base 111, is installed on the board 180.

In the suction nozzle No. field 142d is stored information for specifying a position of the suction nozzle 123 in the head 121, which sucks the component of a type which is arranged at a position where the feeder 111a specified by the feeder No. field 142e is mounted in the feeder base 111. As the information for specifying the position, suction nozzle Nos. which are uniquely allocated to positions at which the suction nozzles 123 are mounted in the head 121 are stored in the suction nozzle No. field 142d.

In the feeder No. field 142e is stored information for specifying a position in the feeder base 111 where the feeder 111a, which holds the component installed at coordinates specified by the component installation coordinate field 142c in the order specified by the order field 142b, is mounted in the feeder base 111. In this embodiment, as information for specifying the mounted position in the feeder base 111, feeder Nos., which are identification information for uniquely identifying the mounted positions in the feeder base 111, are stored in the feeder No. field 142e.

In the apparatus information storage area 143 is stored apparatus information for specifying the individual of the component mounting apparatus 100 and the type of the component mounting apparatus 100. For example, in this embodiment, an apparatus information table 143a shown in FIG. 5 is stored in the apparatus information storage area 143.

As shown in FIG. 5, the apparatus information table 143a includes an apparatus ID field 142b and an apparatus type field 142c.

In the apparatus ID field 143b is stored information for specifying the individual of the component mounting apparatus 100.

In the apparatus type field 142c is stored information for specifying the type of the component mounting apparatus 100. When the information stored in the apparatus type field 142c of the component mounting apparatus 100 matches the information stored in the apparatus type field of the component mounting apparatus 200, those information indicates that the component mounting apparatus 100 and the component mounting apparatus 200 are similar in configuration to each other.

The overall control part 144 controls processing of the feeding device 110, the installing device 120, the abnormality detecting device 130, the arithmetic device 150, the input part 170, the output part 171, and the communication IF part 172.

For example, the overall control part 144 outputs an necessary instruction to the feeding device 110 and the installing device 120 so that the component is installed by the suction nozzle 123 illustrated in FIG. 1 at the installation coordinates in the order specified by the apparatus information table 142a shown in FIG. 4.

Also, the overall control part 144 outputs a necessary instruction to the abnormality detecting device 130 so as to detect the abnormalities of the component and the suction posture of the component at necessary timing.

When the abnormality detecting device 130 detects the abnormality, the overall control part 144 transmits, to the arithmetic device 150, information indicative of the occurrence of the abnormality, information indicative of a time when the abnormality occurs, information for specifying a position of the suction nozzle 123 that conducts the operation of sucking the component when the abnormality occurs on the head 121, and information for specifying a position of the feeder 111a (refer to FIG. 2) in which the operation of sucking the component is conducted by the suction nozzle 123 when the abnormality occurs, on the feeder base 111. After transmission, the overall control part 144 again executes the sucking operation when the abnormality occurs.

When the abnormality detecting device 130 detects the abnormalities of a frequency that satisfies a specific condition, the overall control part 144 stops the installation of the component, and transmits information indicative of an apparatus stop to the abnormality detecting device 130. In this example, the specific condition is that 10 abnormalities are detected by the abnormality detecting device 130 within 1 minute.

The IF part 145 is an interface for transmitting and receiving the information through the bus 173.

(Arithmetic Device)

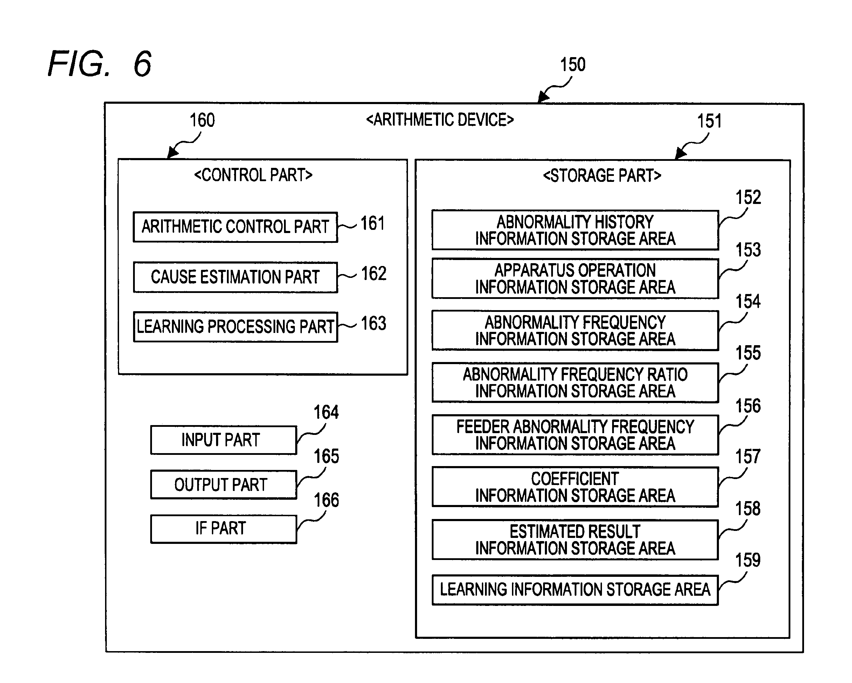

FIG. 6 is a diagram illustrating the configuration of the arithmetic device 150. As illustrated in FIG. 6, the arithmetic device 150 includes a storage part 151, a control part 160, an input part 164, an output part 165, and an IF part 166.

1) Storage Part

The storage part 151 includes an abnormality history information storage area 152, an apparatus operation information storage area 153, an abnormality frequency information storage area 154, an abnormality frequency ratio information storage area 155, a feeder abnormality frequency information storage area 156, a coefficient information storage area 157, an estimated result information storage area 158, and a learning information storage area 159.

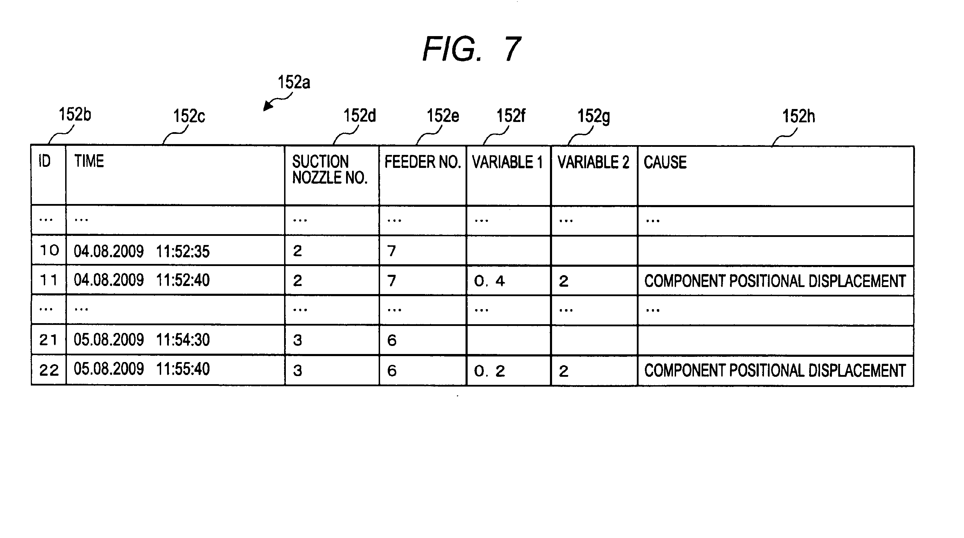

In the abnormality history information storage area 152 is stored abnormality history information for specifying information for specifying order in which the abnormalities occur, a time when each abnormality occurs, a position of the suction nozzle where each abnormality occurs, a position of the feeder where each abnormality occurs, a value used for estimating a cause of each abnormality, and the cause of each abnormality. For example, in this embodiment, an abnormality history information table 152a shown in FIG. 7 is stored in the abnormality history information storage area 152.

As shown in FIG. 7, the abnormality history information table 152a includes an ID field 152b, a time field 152c, a suction nozzle No. field 152d, a feeder No. field 152e, a variable 1 field 152f, a variable 2 field 152g, and a cause field 152h.

At each row of the ID field 152b is stored information for specifying the order of the abnormalities that occur in the component mounting apparatus 100. As values stored in the ID field 152b are smaller, corresponding abnormalities occur earlier.

At each row of the time field 152c is stored information for specifying a time when the abnormality specified by each value stored in the ID field 152b occurs.

At each row of the suction nozzle No. field 152d is stored information for specifying a position of the suction nozzle 123 on the head 121 where the abnormality specified by each value stored in the ID field 152b occurs.

At each row of the suction nozzle No. field 152e is stored information for specifying a position of a feeder 111a on a feeder base 111 where the abnormality specified by each value stored in the ID field 152b occurs.

At each row of the variable 1 field 152f is stored information for specifying a value used for calculation of a cause estimation part 162 that will be described later when the abnormality specified by each value stored in the ID field 152b occurs. In the case where the calculation is not conducted by the cause estimation part 162 when the abnormality occurs, no value is stored and blank is left in the row.

At each row of the variable 2 field 152g is stored information for specifying a value used for calculation of the cause estimation part 162 that will be described later when the abnormality specified by each value stored in the ID field 152b occurs. In the case where the calculation is not conducted by the cause estimation part 162 when the abnormality occurs, no value is stored and blank is left in the row.

At each row of the cause field 152h is stored information for specifying the cause of the abnormality specified by the value stored in the ID field 152b. When no cause is not input when the abnormality occurs, no value is stored and blank is left in the row.

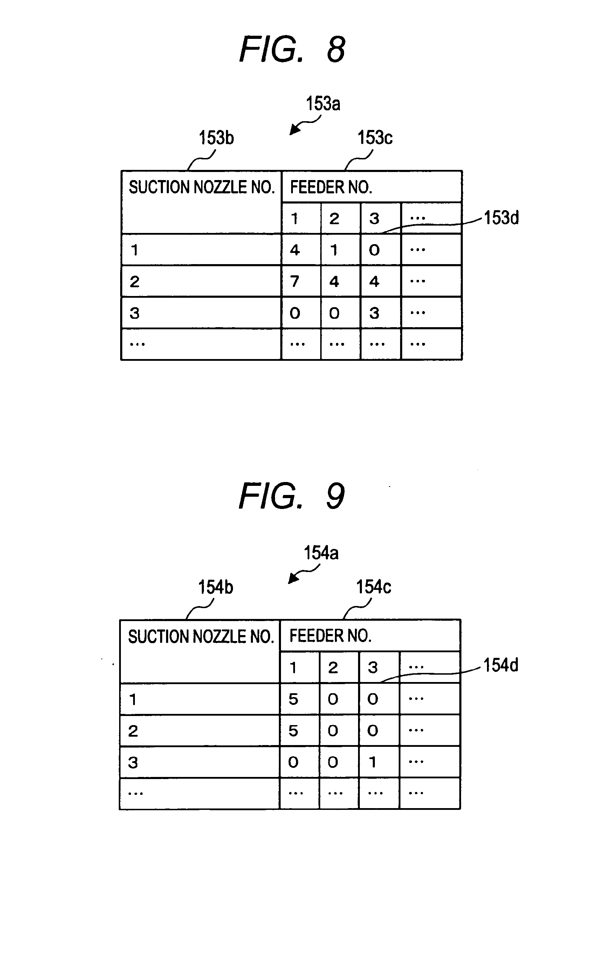

In the apparatus operation information storage area 153 is stored apparatus operation information for specifying the operation frequency of a specific component or site of the component mounting apparatus 100. For example, in this embodiment, an apparatus operation information table 153a shown in FIG. 8 is stored in the apparatus operation information storage area 153.

As shown in FIG. 8, the apparatus operation information table 153a includes a suction nozzle No. field 153b, a feeder No. field 153c, and a suction frequency field 153d.

At each row of the suction nozzle No. field 153b is stored information for specifying a position of the suction nozzle 123 on the head 121.

At each row of the feeder No. field 153c is stored information for specifying a position of the feeder 111a on the feeder base 111.

In the suction frequency field 153d is stored information for specifying a frequency of sucking the components from the feeder 111a mounted at a position specified at each row of the feeder No. field 153c, by the suction nozzle 123 arranged at a position specified at each row of the suction nozzle No. field 153b. In the suction frequency field 153d is stored a value of "0" as an initial value.

In this embodiment, the suction frequency resulting from combination of the suction nozzle 123 with the feeder 111a is stored in the apparatus operation information storage area 153. However, the present invention is not limited to such a configuration, and another index for specifying the operation frequency of the specific component or site of the component mounting apparatus 100 can be stored in the apparatus operation information storage area 153.

In the abnormality frequency information storage area 154 is stored information for specifying a frequency of the abnormalities occurring in the specific component or site of the component mounting apparatus 100. For example, in this embodiment, an abnormality frequency information table 154a shown in FIG. 9 is stored in the abnormality frequency information storage area 154.

As shown in FIG. 9, the abnormality frequency information table 154a includes a suction nozzle No. field 154b, a feeder No. field 154c, and an abnormality frequency field 154d.

At each row of the suction nozzle No. field 154b is stored information for specifying a position of each the suction nozzle 123 on the head 121.

At each row of the feeder No. field 154c is stored information for specifying a position of each feeder 111a on the feeder base 111.

In the abnormality frequency field 154d is stored information for specifying a frequency of the abnormalities measured when the components are sucked from the feeder 111a mounted at a position specified at each row of the feeder No. field 154c, by the suction nozzle 123 arranged at a position specified at each row of the suction nozzle No. field 154b. In the abnormality frequency field 154d is stored a value of "0" as an initial value.

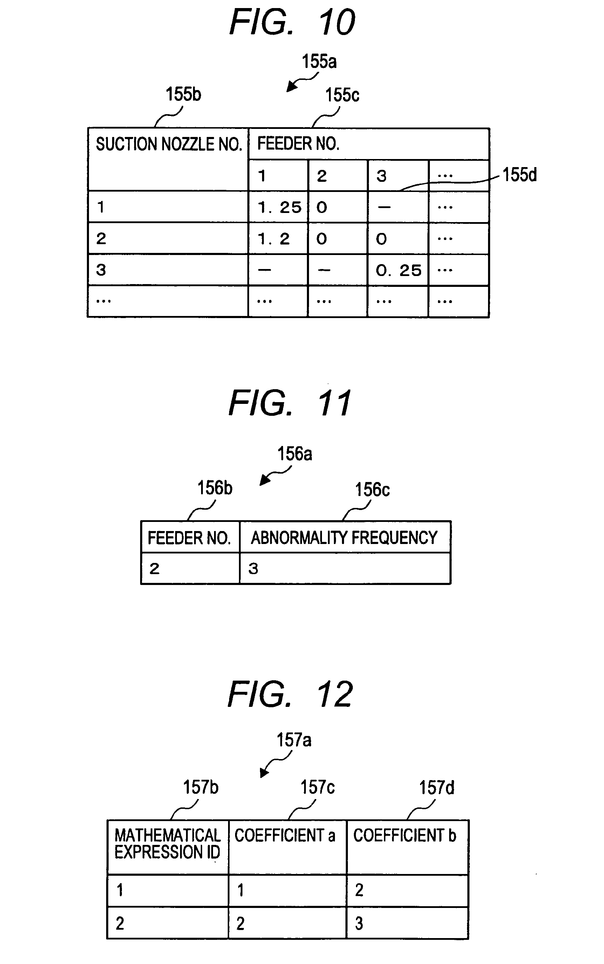

In the abnormality frequency ratio information storage area 155 is stored abnormality frequency ratio information table 155a for specifying a ratio at which the abnormality occurs in the specific component or site of the component mounting apparatus 100. For example, in this embodiment, an abnormality frequency ratio information table 155a shown in FIG. 10 is stored in the abnormality frequency ratio information storage area 155.

As shown in FIG. 10, the abnormality frequency ratio information table 155a includes a suction nozzle No. field 155b, a feeder No. field 155c, and an abnormality frequency ratio field 155d.

At each row of the suction nozzle No. field 155b is stored information for specifying a position of the suction nozzles 123 on the head 121.

At each row of the feeder No. field 155c is stored information for specifying a position of each feeder 111a on the feeder base 111.

In the abnormality frequency ratio field 155d is stored information for specifying a ratio of the frequency of the abnormalities measured when the components are sucked from the feeder 111a mounted at a position specified at each row of the feeder No. field 155c, by the suction nozzle 123 arranged at a position specified at each row of the suction nozzle No. field 155b, to a frequency of the components sucked from the feeder 111a mounted at a position specified at each row of the feeder No. field 155c by the suction nozzle 123 arranged at a position specified at each row of the suction nozzle No. field 155b. In the abnormality frequency ratio field 155d is stored a value of "-" indicating that there is no data as the initial value.

In the feeder abnormality frequency information storage area 156 is stored information for specifying a frequency of the abnormalities occurring when the components are sucked from each feeder 111a mounted on the feeder base 111. For example, in this embodiment, a feeder abnormality frequency information table 156a shown in FIG. 11 is stored in the feeder abnormality frequency information storage area 156.

As shown in FIG. 11, the feeder abnormality frequency information table 156a includes a feeder No. field 156b and an abnormality frequency field 156c.

In the feeder No. field 156b is stored information for specifying a position of each feeder 111a on the feeder base 111.

In the abnormality frequency field 156c is stored information for specifying a frequency of the abnormalities occurring when the components are sucked from the feeder 111a mounted at a position specified by the feeder No. field 156b.

In the coefficient information storage area 157 is stored information for specifying a value input to a mathematic expression when the calculation of the cause estimation part 162 which will be described later is executed. For example, in this embodiment, a coefficient information table 157a shown in FIG. 12 is stored in the coefficient information storage area 157.

As shown in FIG. 12, the coefficient information table 157a includes a mathematic expression ID table 157b, a coefficient a table 157c, and a coefficient b table 157d.

In the mathematic expression ID table 157b is stored information for specifying a mathematic expression used when the cause estimation part 162 executes the calculation.

In the coefficient a table 157c is stored information for specifying a value input to a coefficient of a mathematic expression specified by the mathematic expression ID table 157b when the cause estimation part 162 executes the calculation.

In the coefficient b table 157d is stored information for specifying a value input to a coefficient b of a mathematic expression specified by the mathematic expression ID table 157b when the cause estimation part 162 executes the calculation.

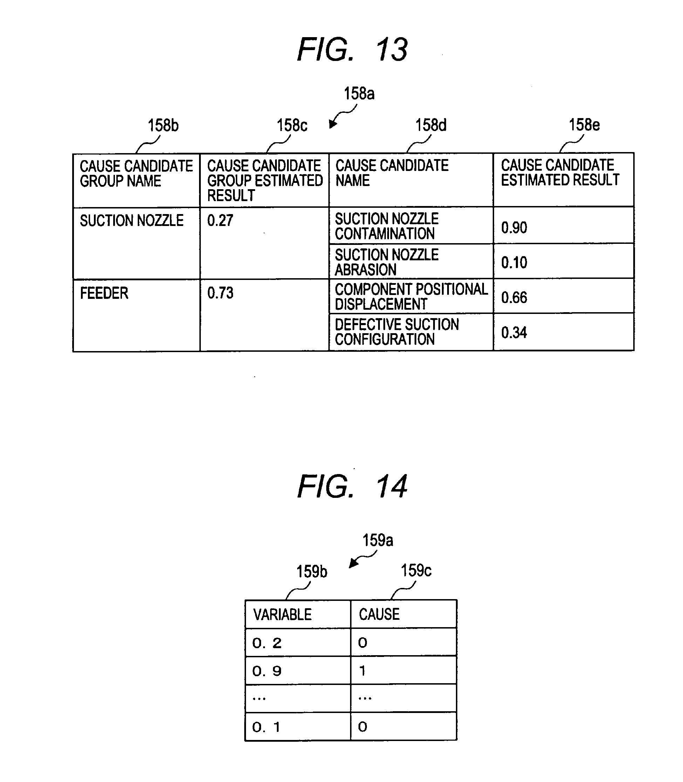

In the estimated result information storage area 158 is stored estimated result information for specifying the cause of the abnormality occurring in the component mounting apparatus 100. For example, in this embodiment, an estimated result information table 158a shown in FIG. 13 is stored in the estimated result information storage area 158.

As shown in FIG. 13, the estimated result information table 158a includes a cause candidate group name field 158b, a cause candidate group estimated result field 158c, a cause candidate name field 158d, and a cause candidate estimated result field 158e.

In the cause candidate group name field 158b is stored information for specifying a group of the causes of the abnormalities occurring in the component mounting apparatus 100. In this embodiment, information for specifying a name (in this example, "suction nozzle" or "feeder") of a site in which the abnormality occurs as the group of the causes of the abnormalities is stored in the cause candidate group name field 158b. The cause candidate specified by information stored in the cause candidate name field 158d which will be described is defined as belonging to the cause candidate group specified by information stored at the same row among the information stored in the cause candidate group name field 158b. In this embodiment, "suction nozzle contamination" and "suction nozzle abrasion" are defined as belonging to the cause candidate group of "suction nozzle".

In the cause candidate group estimated result field 158c is stored information for specifying the level of possibility that the cause candidate belonging to the group specified by the cause candidate group name field 158b contributes to the abnormality occurring in the component mounting apparatus 100. For example, in this embodiment, when "1" is stored in this field, there is the high possibility that the cause candidate belonging to the group specified by the cause candidate group name field 158b contributes to the abnormality occurring in the component mounting apparatus 100. On the other hand, when "0" is stored in this field, such a possibility is low.

In the cause candidate name field 158d is stored information for specifying the cause candidate belonging to the group of the cause candidates specified by the cause candidate name group field 158b. In this embodiment, in this field is stored information for specifying the cause of the abnormality that may occur in the site of a name specified by the cause candidate name group field 158b (in this example, the contamination of the suction nozzles 123, the abrasion of the suction nozzles 123, the displacement of the suction position of the component mounted on the feeder 111a, or the defect of the configuration of the component mounted on the feeder 111a).

In the cause candidate estimated result field 158e is stored information for specifying the level of possibility that the cause specified by the cause candidate group name field 158d contributes to the abnormality occurring in the component mounting apparatus 100. For example, in this embodiment, when "1" is stored in this field, there is the high possibility that the cause candidate specified by the cause candidate group name field 158b contributes to the abnormality occurring in the component mounting apparatus 100. On the other hand, when "0" is stored in this field, such a possibility is low.

In the learning information storage area 159 is stored information for specifying a value used for calculation in a learning processing part 163 which will be described later. For example, in this embodiment, a learning information table 159a shown in Fig. 14 is stored in the learning information storage area 159.

As shown in FIG. 14, the learning information table 159a includes a variable table 159b and a cause table 159c.

In the variable table 159b is stored information for specifying a value used for calculation in the cause estimation part 162 which will be described later.

In the cause table 159c is stored information for specifying the cause of the abnormality occurring in the component mounting apparatus 100. In this embodiment, numerical values are allocated to the cause candidate group and the cause candidate, and information for specifying the numerical values that have been allocated to the cause candidate group and the cause candidate, which cause the abnormality, is stored in the cause table 159c (for example, "1" is allocated to "suction nozzle", and "0" is allocated to "feeder" in advance, and when "suction nozzle contamination" causes the abnormality, 1 that is a value allocated to "suction nozzle" of the cause candidate group to which "suction nozzle contamination" belongs is stored in the cause table 159c).

2) Control Part

The control part 160 includes an arithmetic control part 161, a cause estimation part 162, and a learning processing part 163.

The arithmetic control part 161 controls overall processing in the arithmetic device 150.

First, the arithmetic control part 161 acquires necessary information from the abnormality detecting device 130 and the overall control device 140, stores the acquired information in the abnormality history information storage area 152, and conducts updating.

In response to an instruction from an operator of the arithmetic device 150, the cause estimation part 162 performs a process of calculating an abnormality frequency ratio for each combination of the suction nozzles 123 with the feeders 111a on the basis of the information stored in the apparatus operation information table 153a and the abnormality history information table 152a, and storing the calculated abnormality frequency ratio in the abnormality frequency ratio table 155a. The cause estimation part 162 also performs a process of calculating the abnormality frequency of each feeder 111a on the basis of the information stored in the abnormality history information table 152a, and storing the calculated abnormality frequency in the feeder abnormality frequency information table 156a.

Also, the cause estimation part 162 calculates the variances of the respective abnormality frequency ratios of the suction nozzle 123 and the feeder 111a where the abnormality occurs, and compares those variances with each other. With this comparison, the cause estimation part 162 specifies (estimates) which of the suction nozzle 123 and the feeder 111a have the higher possibility that the abnormality occurs, and stores a variable used for estimation in the abnormality history information table 152a.

Also, the cause estimation part 162 specifies (estimates) which of the positional displacement of the component and the defect of the component configuration is higher in the possibility of the abnormality cause, in the feeder 111a where the abnormality occurs, by using the feeder abnormality frequency. The cause estimation part 162 then stores a variable used for estimation in the abnormality history information table 152a.

Further, the cause estimation part 162 conducts a process of processing information for specifying the cause candidate high in the possibility of the abnormality cause in a predetermined format, and outputting the processed information to the output part 165. The cause estimation part 162 also stores information for specifying the cause of the abnormality input by the operator in the abnormality history information table 152a.

In response to an instruction from the operator of the arithmetic device 150, the learning processing part 163 conducts a process of reading information for specifying the variable input to the mathematic expression instructed to learn, from information stored in the abnormality history information table 152a or an abnormality history information table of the component mounting apparatus 200 to be described later which is a component mounting apparatus other than the component mounting apparatus 100, and storing the read information in the learning information table 159a. The learning processing part 163 also conducts a process of reading information for specifying the cause of the abnormality from information stored in the arithmetic history information table 154a or an arithmetic history information table of the component mounting apparatus 200 which is a component mounting apparatus other than the component mounting apparatus 100, converting the read information into a numerical value, and storing the converted numerical value in the learning information table 159a.

The learning processing part 163 conducts a process of determining a coefficient of the mathematical expression so that a difference between an output value of the mathematical expression used for the cause estimation and a numerical value into which the information for specifying the cause of the abnormality is converted becomes smallest, from the information stored in the learning information table 159a, and storing the determined coefficient in the coefficient information table 157a.

(Input/output part, IF part)

The input part 164 receives an input of information.

The output part 165 outputs information.

The IF part 166 is an interface for transmitting and receiving information through the bus 173.

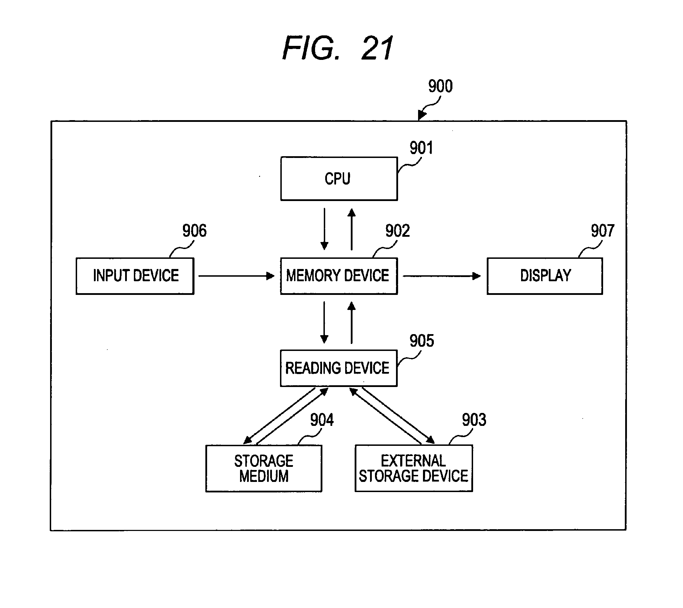

The arithmetic device 150 described above can be realized by, for example, a general computer 900 including a CPU (central processing unit) 901, a memory 902, an external storage device 903 such as an HDD (hard disk drive), a reading device 905 that reads and writes information with respect to a storage medium 904 having a portability such as a CD (compact disk) or a DVD (digital versatile disk) as shown in FIG. 21 (a schematic diagram of the computer 900), an input device 906 such as a keyboard or a mouse, an output device 907 such as a display, and an I/F (interface) for connection to the bus 173.

The storage part 151 can be realized by, for example, allowing the CPU 901 to use the memory 902 or the external storage device 903. The control part 160 can be realized by allowing a given program stored in the external storage device 903 to be loaded into the memory 902 and executed by the CPU 901. The input part 164 can be realized by allowing the CPU 901 to use the input device 906, and the output part 165 can be realized by allowing the CPU 901 to use the output device 907. The IF part 166 can be realized by allowing the CPU 901 to use the I/F .

The given program may be downloaded into the external storage device 903 from the storage medium 904 through the reading device 905, or from a network through a communication device not shown, then loaded into the memory 902, and executed by the CPU 901. Alternatively, the given program may be downloaded directly into the memory 902 from the storage medium 904 through the reading device 905, or from a network through a communication device not shown, and executed by the CPU 901.

Returning to FIG. 1, the input part 170 is an input device for receiving an input of information, and can be configured by, for example, a mouse or a keyboard.

The output part 171 is an output device for outputting information, and can be configured by, for example, a display.

The communication IF part 172 is an interface for transmitting or receiving information with respect to other apparatuses through the network.

The bus 173 is a communication channel for communicating with the feeding device 110, the installing device 120, the abnormality detecting device 130, the overall control device 140, the arithmetic device 150, the input part 170, the output part 171, the communication IF part 172, and the component mounting apparatus 200.

(Another component mounting apparatus)

The component mounting apparatus 200 includes, as in the component mounting apparatus 100, a feeding device having the same configuration as the feeding device 110, an installing device having the same configuration as the installing device 120, an abnormality detecting device having the same configuration as the abnormality detecting device 130, an overall control device having the same configuration as the overall control device 140, an arithmetic device having the same configuration as the arithmetic device 150, an input part having the same configuration as the input part 170, an output part having the same configuration as the output part 171, a communication IF part having the same configuration as the communication IF part 172, and a bus having the same configuration as the bus 173.

Hereinafter, various processing flows (a process of updating the abnormality history information, a process of specifying the abnormality cause, and a process of learning a function used for cause estimation) which are executed in the arithmetic device 150 will be described in detail.

(Process of updating abnormality history information)

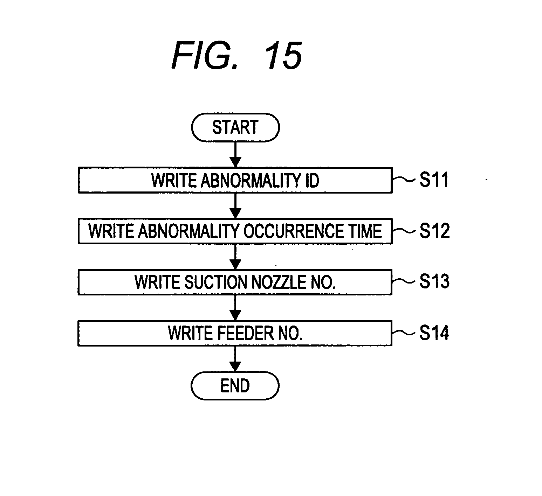

FIG. 15 is a flowchart showing a process of updating the abnormality history information in the arithmetic device 150.

The arithmetic control part 161 of the arithmetic device 150 first starts processing, upon receiving from the overall control device 140 through the IF part 166, information indicating that the abnormality occurs in the component suction of the installing device 120, information for specifying a time when the abnormality occurs, information for specifying a position of the suction nozzle 123 in which the abnormality occurs on the head 121, and information for specifying a position of the feeder 111a in which the abnormality occurs on the feeder base 111.

In Step S11, the arithmetic control part 161 stores information for specifying the abnormality in the abnormality history information table 152a.

The arithmetic control part 161, for example, in Step S11, retrieves the largest value from the information stored in the ID field 152b, and stores a value resulting from adding 1 to the largest value in a row next to a row in which the largest value is stored in the IF field 152b. When no information is stored in the ID field 152b, the arithmetic control part 161 stores "1" in a first row of the ID field 152b. In this example, a row in which the value is stored in the ID field 152b is called "r11".

In Step S12, the arithmetic device 161 stores the information for specifying the time when the abnormality occurs in the abnormality history information table 152a.

The arithmetic device 161 stores the information indicative of the time when the abnormality occurs, which has been transmitted from the overall control device 140, on the r11 low of the time information field 152c, for example, in Step S12.

In Step S13, the arithmetic control part 161 stores the information for specifying the suction nozzle 123 in which the abnormality occurs on the head 121 in the abnormality history information table 152a.

The arithmetic control part 161 stores the information for specifying the position of the suction nozzle 123 in which the abnormality occurs on the head 121, which has been transmitted from the overall control device 140, on the r11 row of the suction nozzle No. field 152d, for example, in Step S13.

In Step S14, the arithmetic control part 161 stores the information for specifying the position of the feeder 111a in which the abnormality occurs on the feeder base 111 in the abnormality history information table 152a.

The arithmetic control part 161 stores the information for specifying the position of the feeder 111a in which the abnormality occurs on the feeder base 111, which has been transmitted from the overall control device 140, on the r11 row of the feeder No. field 152e, for example, in Step S14.

(Process for Specifying Abnormality Cause)

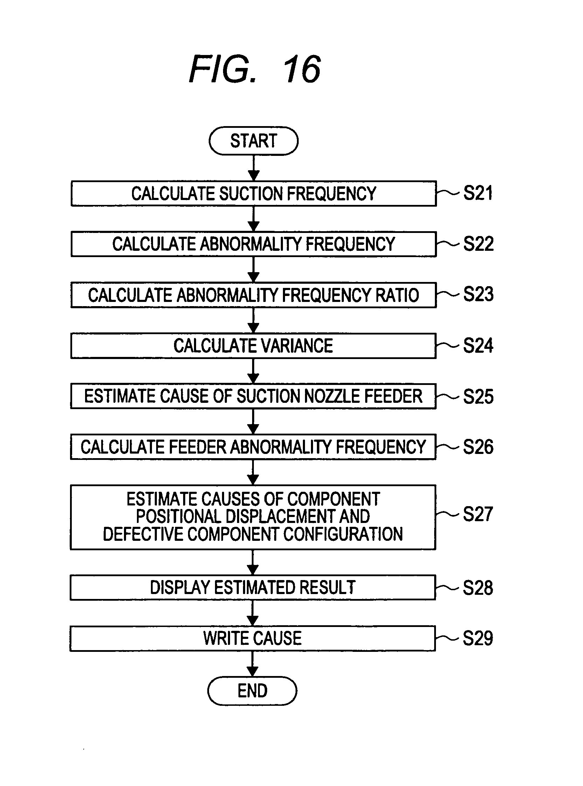

FIG. 16 is a flowchart showing a process of specifying the cause of the abnormality in the arithmetic device 150 illustrated in FIG. 6.

The cause estimation part 162 of the arithmetic device 150 starts processing when information indicative of the apparatus stop due to the abnormality is transmitted from the overall control part 140 through the IF part 166.

In Step S21, the cause estimation part 162 calculates the suction frequency in all combinations of the suction nozzle Nos. and the feeder Nos., generates the apparatus operation information table 153a, and stores the generated table in the apparatus operation information storage area 153.

The cause estimation part 162 adds 1 to the value stored in the suction frequency field 153d in which, for example, the suction nozzle No. specified by the information stored in a first row of the suction nozzle No. field 142d shown in FIG. 4, and the feeder No. specified by the information stored in a first row of the feeder No. field 142e match a row of the suction nozzle No. field 153b and a column of the feeder No. field 153c shown in FIG. 8, respectively, to update the value. Then, the cause estimation part 162 executes the processing that has been subjected to the first row of the suction nozzle No. field 142d and the first row of the feeder No. field 142e with respect to a second row of the suction nozzle No. field 142d and a second row of the feeder No. field 142d to a last row of the suction nozzle No. field 142d and a last row of the feeder No. field 142e.

In Step S22, the cause estimation part 162 calculates the abnormality frequency in all the combinations of the suction nozzle Nos. and the feeder Nos., generates the abnormality frequency information table 154a, and stores the generated table in the abnormality frequency information storage area 154.

The cause estimation part 162 reads, for example, the information stored on the last row of the time field 152c of the abnormality history information table 152a. The cause estimation part 162 then compares a time resulting from subtracting a predetermined time (for example, 10 minutes) from a time specified by the information stored on the last row of the time field 152c of the abnormality history information table 152a with a time specified by the information stored in the time field 152c of the abnormality history information table 152a in each row. In each row, when the time specified by the information stored on all the rows of the time field 152c of the abnormality history information table 152a is after the time resulting from subtracting the predetermined time (for example, 10 minutes) from the time specified by the information stored on the last row of the time field 152c of the abnormality history information table 152a, the cause estimation part 162 reads the respective information stored on the same row of the suction nozzle No. field 152d and the feeder No. field 152e. The cause estimation part 162 adds 1 to a value stored in the abnormality frequency field 154d in which the suction nozzle No. specified by the information stored on the same row of the suction nozzle No. field 152d and the feeder No. specified by the information stored on the same row of the feeder No. field 152e match a row of the suction nozzle No. field 154b and a column of the feeder No. field 154c, respectively, to update the value.

In Step S23, the cause estimation part 162 calculates the abnormality frequency ratios in all combinations of the suction nozzle Nos. and the feeder Nos., generates the abnormality frequency ratio information table 155a, and stores the generated table in the abnormality frequency ratio information storage area 155.

The cause estimation part 162 specifies, for example, each arbitrary combination from all the combinations of the suction nozzle Nos. and the feeder Nos., and conducts the following processing.

First, the cause estimation part 162 reads, in the apparatus operation information table 153a, the suction frequency from a column of the suction frequency field 153d in which the suction nozzle No. and the feeder No. included in a specified combination match a row of the suction nozzle No. field 153b and a column of the feeder NO. field 153c, respectively.

The cause estimation part 162 reads, when the read suction frequency is "1" or more (when the read suction frequency is not 1 or more, processing is advanced to another combination), the abnormality frequency from a field of the abnormality frequency field 154d in which the suction nozzle No. and the feeder No. included in the specified combination match a row of the suction nozzle No. field 154b and a column of the feeder No. field 154c, respectively, in the abnormality history information table 152a.

The cause estimation part 162 calculates the abnormality frequency ratio in each combination of the suction nozzle No. and the feeder No. through the following Expression (1) by using the read suction frequency and abnormality frequency. Then, the cause estimation part 162 stores the calculated abnormality frequency ratio in a field of the abnormality frequency ratio field 155d in which the suction nozzle No. and the feeder No. included in the specified combination match a row of the suction nozzle No. field 155b and a column of the feeder No. field 155c, respectively, in the abnormality frequency ratio information table 155a.

Abnormality frequency ratio = abnormality frequency/suction

frequency …(1)

In Step S24, the cause estimation part 162 calculates a value of variance with respect to the suction nozzle No. specified by the information stored on the last row of the suction nozzle No. field 152d of the abnormality history information table 152a. The suction nozzle No. specified by the information stored on the last row of the suction nozzle No. field 152d of the abnormality history information table 152a is indicative of the suction nozzle No. in which the abnormality occurs immediately before the apparatus stops.

The cause estimation part 162 reads, for example, all the values other than a value of "-", which are stored in all of columns of the abnormality frequency ratio field 155d in which information matching the suction nozzle No. specified by the information stored on the last row of the suction nozzle No. field 152d of the abnormality history information table 152a is stored on the row of the suction nozzle No. field 155b.

Indexes i and j using natural numbers are allocated to the read values in the order from "1", and the value of variance in the suction nozzle is calculated through the following Expression (2).

Variance

$$= \frac{1}{n-1} \sum_{j=1}^{n} \left( D_j - \frac{\sum_{i=1}^{n} D_i}{n} \right)^2 \quad \cdots (2)$$

where Di is a value of the abnormality frequency ratio to which the index i is allocated, Dj is a value of the abnormality frequency ratio to which the index j is allocated, and n is a total of the values of the read abnormality frequency ratio.

In Step S24, the cause estimation part 162 calculates a value of variance with respect to the feeder No. specified by the information stored on the last row of the feeder No. field 152e of the abnormality history information table 152a. The feeder No. specified by the information stored on the last row of the feeder No. field 152e of the abnormality history information table 152a is indicative of a feeder No. in which the abnormality occurs immediately before the apparatus stops.

The cause estimation part 162 reads, for example, all the values other than a value of "-", which are stored in all of columns of the abnormality frequency ratio field 155d in which information matching the feeder No. specified by the information stored on the last row of the feeder No. field 152e of the abnormality history information table 152a is stored on the row of the feeder No. field 155c.

Indexes i and j using natural numbers are allocated to the read values in the order from "1", and the value of variance in the feeder is calculated through the following Expression (2).

In Step S25, the cause estimation part 162 reads a value stored on the first row of the coefficient a table 157c of the coefficient information table 157a, and a value stored on the first row of the coefficient b table 157d of the coefficient information table 157a. The cause estimation part 162 then inputs, to the following Expression (3), a value of variance of the suction nozzles 123 which is calculated in Step S23, a value of variance of the feeders 111a which is calculated in Step S24, a value stored on the first row of the coefficient a table 157c of the coefficient information table 157a, and a value stored on the first row of the coefficient b table 157d of the coefficient information table 157a. The cause estimation part 162 then calculates a value indicative of the degree (Pn) of possibility that the cause candidate, which is a cause of the abnormality, belongs to the cause candidate group of the suction nozzle.

The level of possibility of the cause

$$(Pn) = \frac{1}{1 - \exp[-a_1[Vf/(Vf+Vn) - b_1]]} \quad \cdots (3)$$

Where Vn is a value of variance of the suction nozzles 123 which is calculated in Step S23, Vf is a value of variance of the feeders 111a which is calculated in Step S24, $a_1$ is a value stored on the first row of the coefficient a table 157c of the coefficient information table 157a, and $b_1$ is a value stored on the first row of the coefficient b table 157d of the coefficient information table 157a.

The cause estimation part 162 stores the calculated value on the first row of the cause candidate group estimated result field 158c of the estimated result information table 158a, and stores a value resulting from subtracting the calculated value from 1 on the second row of the cause candidate group estimated result field 158c of the estimated result information table 158a.

Further, the cause estimation part 162 stores the variable 1 calculated through the following Expression (4), which is a value used in Expression (3), on the last row of the variable 1 field 152f of the abnormality history information table 152a.

$$\text{Variable 1} = Vf/(Vf+Vn) \quad \ldots (4)$$

In Step S26, the cause estimation part 162 calculates the abnormality frequency with respect to the feeder No. specified by the information stored on the last row of the feeder No. field 152e of the abnormality history information table 152a.

The cause estimation part 162 reads, for example, the information stored on the last row of the feeder No. field 152e of the abnormality history information table 152a, stores the value read in the feeder No. field 156b of the feeder abnormality frequency information table 156a, and stores "0" in the abnormality frequency field 156c as "0". The cause estimation part 162 reads the information stored on the last row of the time field 152c of the abnormality history information table 152a. The cause estimation part 162 then compares a time obtained by subtracting a predetermined time (for example, 10 minutes) from a time specified by the information stored on the last row of the time field 152c of the abnormality history information table 152a with a time specified by the information stored in the time field 152c of the abnormality history information table 152a, with respect to all of the rows. The cause estimation part 162 also compares a feeder No. specified by the information stored on the last row of the feeder No. field 152e with a feeder No. specified by the information stored in the feeder No. field 152e. At each of the rows, there is a case in which the time specified by the information stored on all the rows of the time field 152c of the abnormality history information table 152a is after the time obtained by subtracting the predetermined time (for example, 10 minutes) from the time specified by the information stored on the last row of the time field 152c of the abnormality history information table 152a, and the feeder No. specified by the information stored on the last row of the feeder No. field 152e matches the feeder No. specified by the information stored in the feeder No. field 152e. In this case, the cause estimation part 162 adds 1 to the value stored in the abnormality frequency field 156c of the feeder abnormality frequency information table 156a, and updates the value.

In Step S27, the cause estimation part 162 reads the value stored on the second row of the coefficient a table 157c of the coefficient information table 157a, the value stored on the second row of the coefficient b table 157d of the coefficient information table 157a, and the value stored in the feeder No. field 156b of the feeder abnormality frequency information table 156a. The cause estimation part 162 then inputs, to the following Expression (5), the value stored on the first row of the coefficient a table 157c of the coefficient information table 157a, the value stored on the first row of the coefficient b table 157d of the coefficient information table 157a, and the value stored in the abnormality frequency field 156c of the feeder abnormality frequency information table 156a. The cause estimation part 162 then calculates a value indicative of the level (Pf) of possibility that the cause candidate of the component positional displacement causes an abnormality.

The level of possibility of the cause (Pf) =

$$= \frac{1}{1 - \exp[-a_2[c - b_2]]} \quad \cdots (5)$$

where c is a value stored in the abnormality frequency field 156c of the feeder abnormality frequency information table 156a, $a_2$ is a value stored on the second row of the coefficient a table 157c of the coefficient information table 157a, and $b_2$ is a value stored on the second row of the coefficient b table 157d of the coefficient information table 157a.

The cause estimation part 162 stores the calculated value on the third row of the cause candidate estimated result field 158e of the estimated result information table 158a, and stores a value obtained by subtracting the calculated value from 1 on the fourth row of the cause candidate estimated result field 158e of the estimated result information table 158a.

The cause estimation part 162 further stores a value stored in the abnormality frequency field 156c of the feeder abnormality frequency information table 156a, which is used in Expression (5), on the last row of the variable 2 field 152g of the abnormality history information table 152a.

In Step S28, the cause estimation part 162 processes the information stored in the estimated result information table 158a into a predetermined display screen, and outputs the display screen to another apparatus through the output part 165 and the IF part 166.

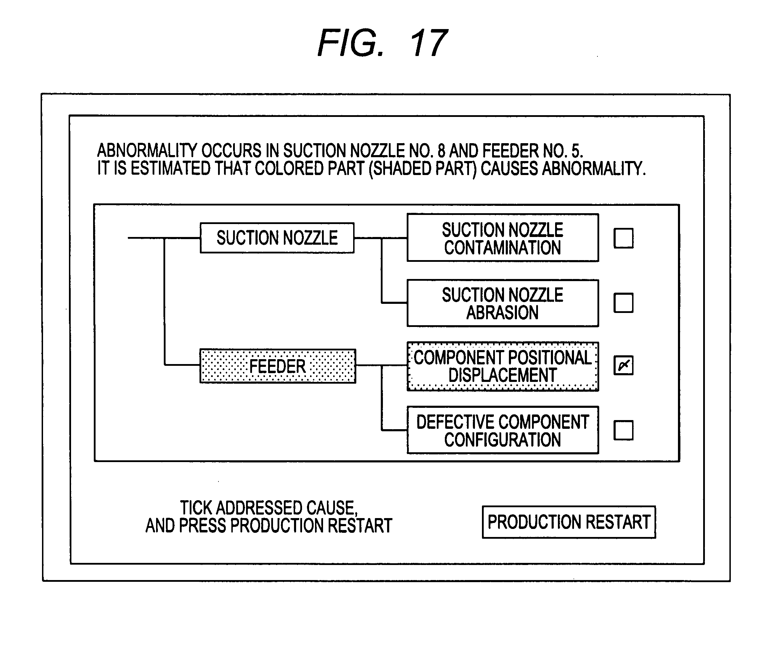

For example, as shown in FIG. 17 (a schematic diagram of the display screen in the output part 171), the cause estimation part 162 creates a tree structure having the information stored in the cause candidate group name field 158b of the estimated result information table 158a as a parent element and the information stored in the cause candidate name field 158d as a subelement. The cause estimation part 162 then displays elements corresponding to information stored in the cause candidate group name field 158b and the cause candidate name field 158d of record in which a value of 0.5 or more is stored in the cause candidate group estimated result field 158c and the cause candidate estimated result field 158e to be discriminable from the other elements.

In this embodiment, for example, the elements in question are added with a color different from that of the other elements so as to be discriminable. However, the present invention is not limited to this configuration.

Also, in this embodiment, one kind of color is added to the elements in question so as to be discriminable. However, the elements in question can be discriminated by using a plurality of colors such that the color is deepened in proportion to the magnitude of the values stored in the cause candidate group estimated result field 158c and the cause candidate estimated result field 158e.

In Step S28, the cause estimation part 162 stores the cause of the abnormality measured by the operator therein, and transmits the information for instructing restart of the component suction to the overall control device 140.

When the operator ticks the cause candidate developed as a real cause of the abnormality, and clicks a production restart button, for example, as shown in FIG. 17 (a schematic diagram of the display screen in the output part 171), the cause estimation part 162 stores the name of the ticked cause candidate on the last row of the cause field 152h of the abnormality history information table 152a, and transmits information indicative of restart of the component suction to the overall control device 140.

(Process of Learning Function used for Cause Estimation)

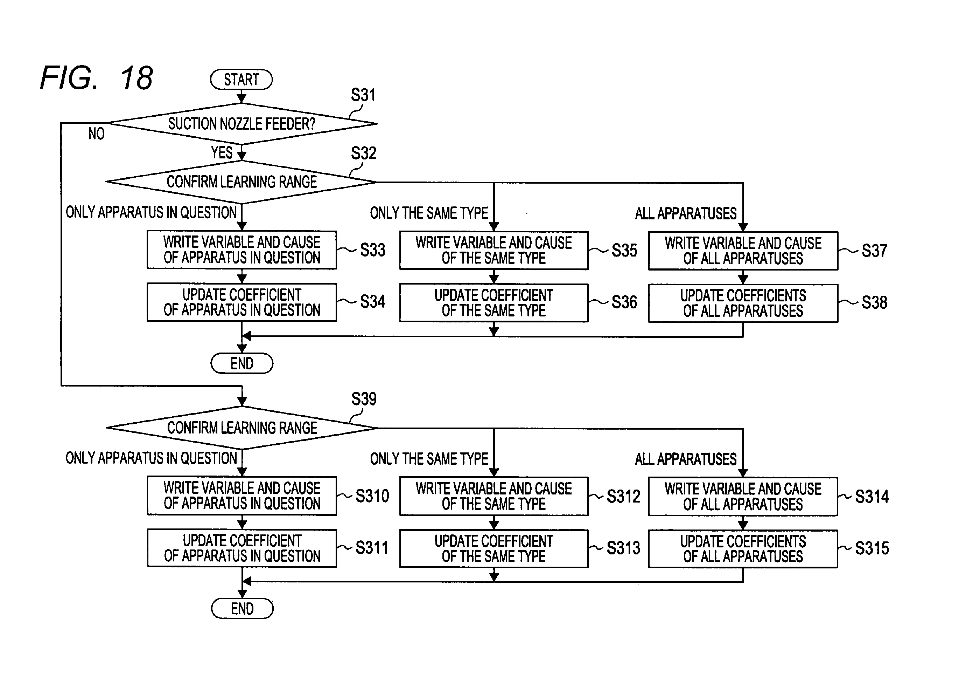

FIG. 18 is a flowchart showing a process of learning a function used for the cause estimation in the arithmetic device 150 shown in FIG. 6.

The learning processing part 163 of the arithmetic device 150 starts processing when information for instructing execution of the learning is transmitted from the input part 170 or the communication IF part 172 shown in FIG. 1 through the IF part 166.

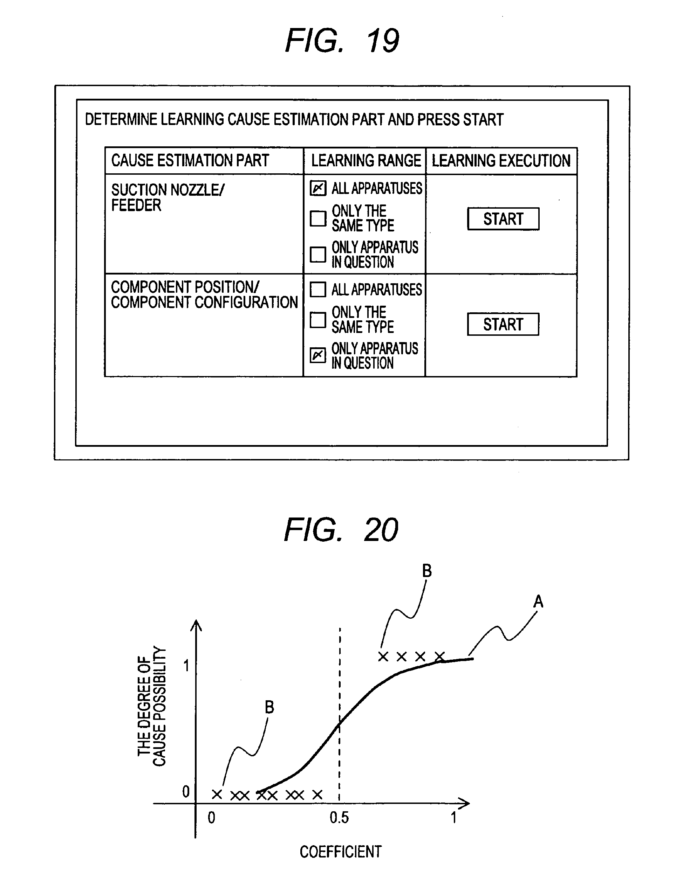

For example, the learning processing part 163 starts processing when the operator ticks any one of learning ranges, and clicks any one of start buttons for execution of the learning, as shown in FIG. 19 (a schematic diagram of the display screen in the output part 171)

The learning processing part 163 conducts the processing of Step S32 when the start button located on a row of "suction nozzle/feeder" is clicked, and conducts the processing of Step S39 when the start button of "component position/component configuration" is clicked (S31).

The learning processing part 163 confirms the learning range on the row of "suction nozzle/feeder", and executes Step S33 when "only the apparatus in question" is checked, Step S35 when "only the same type" is checked, and Step S37 when "all the apparatuses" is checked (S32).

In Step S33, the learning processing part 163 reads the information of the abnormality history information table 152a, and stores the information in the learning information table 159a.

The learning processing part 163 confirms whether the information is stored in the cause field 152h on each row with respect to all the rows of the abnormality history information table 152a, or not. The learning processing part 163 reads the information stored in the variable 1 field 152f and the information stored in the cause field 152h for each row in which the information is stored. The learning processing part 163 stores the information stored in the variable 1 field 152f on the last row of the variable field 159b of the learning information table 159a. When the information stored in the cause field 152h is "suction nozzle contamination" and "suction nozzle abrasion", the learning processing part 163 stores "1" on the last row of the variable field 159b of the learning information table 159a. When the information stored in the cause field 152h is "component positional displacement" and "defective component configuration", the learning processing part 163 stores "0" on the last row of the variable field 159b of the learning information table 159a.

In Step S34, the learning processing part 163 reads the information of the learning information table 159a, and updates the information of the coefficient information table 157a.

The learning processing part 163, for example, reads values stored in the variable field 159b and the time field 152c of the learning information table 159a, and calculates a value of a coefficient through the following Expression (6).

Coefficient

$$= \left[ \frac{\sum_{i=1}^{n}(d_i \times e_i)}{\sum_{i=1}^{n} e_i} + \frac{\sum_{i=1}^{n}[d_i \times (1-e_i)]}{\sum_{i=1}^{n}(1-e_i)} \right] \times \frac{1}{2} \qquad \cdots(6)$$

where $d_i$ is a value stored on an i-th row of the variable field 159b of the learning information table 159a, and $e_i$ is a value stored on an i-th row of the cause field 159c of the learning information table 159a.

A first term of the right side in Expression (6) represents an average value of the values stored in the learning information storage area 159 stored on the row where "1" is stored in the cause field 159c. A second term of the right side represents an average value of the values stored in the learning information storage area 159 stored on the row where "1" is stored in the cause field 159c.

Further, the learning processing part 163 stores the value of the coefficient calculated in Expression (6) on the first row of the coefficient b field 157c of the coefficient information table 157a. As a result, when processing of Step S25 in a flowchart shown in FIG. 16 is then executed by the cause estimation part 162, a value indicated by a curve in FIG. 20 is calculated as a value representative of the level of possibility that the cause candidate that causes the abnormality belongs to the cause candidate group of "suction nozzle". The axis of ordinate in FIG. 20 represents the level of possibility that the cause candidate belongs to the cause candidate group of "suction nozzle", and the axis of abscissa represents the value of the coefficient calculated in Expression (6). A curve A in FIG. 20 represents a locus of Expression (1) after learning, and plot groups of data indicated by B represent data on each row of the learning information table. In this example, the axis of ordinate is the value calculated through Expression (1) or the value stored in the cause field 159c. The axis of abscissa is the value stored in the variable 1 field 152f in Expression (1) or the value stored in the variable field 159b. That is, values larger than 0.5 are calculated in an area where there is many pieces of data that the cause candidate causing the abnormality belongs to the cause candidate group of "suction nozzle" (on the right side of the graph in FIG. 20), and values smaller than 0.5 are calculated in an area where there is many pieces of data that the cause candidate causing the abnormality belongs to the cause candidate group of "feeder" (on the left side of the graph in FIG. 20).

In Step S35, the learning processing part 163 reads the information of the abnormality history information table 152a and the abnormality information history of a component mounting apparatus which is the same type as that of the component mounting apparatus 100, and stores the read information and history in the learning information table 159a.

The learning processing part 163, for example, conducts the same processing as that in Step S33 in the abnormality history information table 152a, and reads the apparatus type information stored in the apparatus type field 142c of the apparatus information table 142a. Then, the learning processing part 163 reads the abnormality history information on the component mounting apparatus in which the same apparatus type information as the apparatus type information stored in the apparatus type field 142c is stored in the device information table, through the communication IF part 172, and conducts the same processing as that in Step S33.

In Step S36, the learning processing part reads the information of the learning information table 159a, and updates the information of the coefficient information table 157a, and the coefficient information of the component mounting apparatus which is the same apparatus type as that of the component mounting apparatus 100.

The learning processing part 163, for example, conducts the same processing as that in Step S34 on the learning information table 159a and the coefficient information table 157a. The learning processing part 163 then reads the apparatus type information stored in the apparatus type field 142c of the apparatus information table 142a. The learning processing part 163 then stores the calculated value of the coefficient in the coefficient information table of the component mounting apparatus in which the same apparatus type information as the apparatus type information stored in the apparatus type field 142c is stored in the apparatus information table.

In Step S37, the learning processing part 163 reads the information of the abnormality history information table 152a, and the abnormality information histories of all the component mounting apparatuses that can communicate with the component mounting apparatus 100 through the communication IF part 172, and stores the read information and histories in the learning information table 159a.

The learning processing part 163, for example, conducts the same processing as that in Step S33 on the abnormality history information table 152a. The learning processing part 163 then reads the abnormality history information on all of the component mounting apparatuses communicatable by the communication IF part 172 through the communication IF part 172, and conducts the same processing as that in Step S33.

In Step S38, the learning processing part reads the information of the learning information table 159a, and updates the information of the coefficient information table 157a and the coefficient information of all the component mounting apparatuses which can communicate with the component mounting apparatus 100 through the communication IF part 172.

The learning processing part 163, for example, conducts the same processing as that in Step S34 on the learning information table 159a and the coefficient information table 157a. The learning processing part 163 then stores the calculated value of the coefficient in the coefficient information tables of all the component mounting apparatuses which can communicate with the component mounting apparatus 100 through the communication IF part 172.

The learning processing part 163 confirms the learning range on the row of "component positional displacement/ defective component configuration", and executes Step S310 when "only the apparatus in question" is ticked. The learning processing part 163 executes Step S312 when "only the same type" is ticked, and executes Step S314 when "all the apparatuses" is ticked (S39).

In Step S310, the learning processing part 163 reads the information of the abnormality history information table 152a, and stores the read information in the learning information table 159a.

The learning processing part 163, for example, confirms whether the information of "component positional displacement" or "defective component configuration" is stored in the cause field 152h on each row with respect to all the rows of the abnormality history information table 152a, or not. The learning processing part 163 then reads the information stored in the variable 2 field 152g and the information stored in the cause field 152h on the rows where the information is stored. The learning processing part 163 then stores the information stored in the variable 2 field 152g on the last row of the variable field 159b of the learning information table 159a. When the information stored in the cause field 152h is "component positional displacement", the learning processing part 163 stores "1" on the last row of the variable field 159b of the learning information table 159a. When the information stored in the cause field 152h is "defective component configuration", the learning processing part 163 stores "0" on the last row of the variable field 159b of the learning information table 159a.

In Step S311, the learning processing part 163 reads the information of the learning information table 159a, and updates the information of the coefficient information table 157a.

For example, the learning processing part 163 reads the values stored in the variable field 159b and the time field 152c of the learning information table 159a, and calculates the value of the coefficient through the above-mentioned Expression (6).

Further, the learning processing part 163 stores the value of the coefficient calculated through Expression (6) on the second row of the coefficient a table 157c of the coefficient information table 157a.

In Step S312, the learning processing part 163 reads the information of the abnormality history information table 152a, and the abnormality information history of the component mounting apparatus which is the same apparatus type as that of the component mounting apparatus 100. The learning processing part 163 then stores the read information and history in the learning information table 159a.

The learning processing part 163, for example, conducts the same processing as that in Step S310, and reads the apparatus type information stored in the apparatus type field 142c of the apparatus information table 142a. The learning processing part 163 then reads the abnormality history information on the component mounting apparatus in which the same apparatus type information as the apparatus type information stored in the apparatus type field 142c is stored in the apparatus information table, through the communication IF part 172. The learning processing part 163 then conducts the same processing as that in Step S310.

In Step S313, the learning processing part reads the information of the learning information table 159a, and updates the information of the coefficient information table 157a and the coefficient information of the component mounting apparatus which is the same apparatus type as that of the component mounting apparatus 100.

The learning processing part 163, for example, conducts the same processing as that of Step S311 on the learning information table 159a and the coefficient information table 157a. The learning processing part 163 then reads the apparatus type information stored in the apparatus type field 142c of the apparatus information table 142a. The learning processing part 163 then stores the calculated value of the coefficient in the coefficient information table of the component mounting apparatus in which the same apparatus type information as the apparatus type information stored in the apparatus type field 142c is stored in the apparatus information table.

In Step S314, the learning processing part 163 reads the information of the abnormality history information table 152a, and the abnormality information history of all the component mounting apparatuses that can communicate with the component mounting apparatus 100 through the communication IF part 172. The learning processing part 163 then stores the read information in the learning information table 159a.

The learning processing part 163, for example, conducts the same processing as that in Step S310 on the abnormality history information table 152a. The learning processing part 163 then reads the abnormality history information on all the component mounting apparatuses communicatable by the communication IF part 172, through the communication IF part 172, and conducts the same processing as that in Step S310.

In Step S315, the learning processing part 163 reads the information of the learning information table 159a, and updates the information of the coefficient information table 157a, and the coefficient information of all the component mounting apparatuses that can communicate with the component mounting apparatus 100 through the communication IF part 172.

The learning processing part 163, for example, conducts the same processing as that in Step S311 on the learning information table 159a and the coefficient information storage area 157, and stores the calculated value of the coefficient in the coefficient information table of all the component mounting apparatuses that can communicate with the component mounting apparatus 100 through the communication IF part 172.

As described above, according to this embodiment, the function that estimates the cause of the abnormality is updated, and the cause candidate that causes the abnormality can be specified (estimated) from the plurality of cause candidates with high precision when the abnormality occurs.

**Claims**

1. A component mounting apparatus with an abnormality detecting device that detects an abnormality occurring when a component is mounted on a board, and presents a cause of the abnormality, the component mounting apparatus comprising:

   a feeding device that conveys and feeds the component onto the board;
   an installing device that installs the fed component on the board
   the abnormality detecting device that detects the abnormality occurring in the feeding device or the installing device;
   an arithmetic device that conducts processing required for estimating a cause of the abnormality; and
   an overall control device that controls the respective devices,

   wherein the arithmetic device includes:

   a storage part that stores therein at least two kinds of information including apparatus information for specifying a frequency at which mounting of the components on the board fails, and cause information for specifying the cause of the abnormality occurring in the component mounting apparatus; and
   a control part that conducts a process of creating a function for determining the cause of the abnormality from a plurality of abnormality cause candidates by using the apparatus information and the cause information, and a process of presenting the cause of a new abnormality by using the function and the frequency at which mounting of the component on the board at a time when the abnormality newly occurs fails, when the abnormality newly occurs.

2. The component mounting apparatus according to claim 1,
   wherein the control part conducts a process of creating the function so that a difference between an output value of the function when the apparatus information is input and a value calculated on the basis of the cause information becomes smaller.

3. The component mounting apparatus according to claim 1, wherein when a plurality of component mounting apparatuses are connected through a bus, the control part conducts a process of creating the function by using the apparatus information provided in each of the plurality of component mounting apparatuses, and the cause information provided in each of the plurality of component mounting apparatuses, or a process of creating a plurality of the functions by using the apparatus information different or the cause information different in each of the functions.

4. The component mounting apparatus according to claim 3, wherein an object range for acquiring the apparatus information is set to any one of the plurality of component mounting apparatuses, or determined according to an instruction that is input through an input part provided in the component mounting apparatus.

5. The component mounting apparatus according to claim 1, wherein the control part conducts a process of creating a function for classifying the cause candidate into a plurality of groups, and determining a group including the cause of the abnormality from the plurality of classified groups, and a process of determining the group including the cause of the abnormality by using the function, and presenting the determined group.

6. The component mounting apparatus according to claim 5, wherein the control part includes, as the plurality of classified groups, a feeder group having cause candidates of the abnormality that is attributed to a configuration of the component installed in the component mounting apparatus, and a cause candidate of the abnormality that is attributed to a position at which a suction nozzle that sucks the component sucks the component, and conducts a process of presenting whether the cause of the abnormality is included in the feeder group, or not, by using the function.

7. The component mounting apparatus according to claim 5, wherein the control part includes, as the plurality of classified groups, a suction nozzle group having a plurality of cause candidates attributed to a suction nozzle that sucks the component, and conducts a process of presenting whether the cause of the abnormality is included in the suction nozzle group, or not, by using the function.

8. The component mounting apparatus according to claim 1, wherein at least one of the arithmetic devices is disposed outside the component mounting apparatus, and connected to the component mounting apparatus through a network.

FIG. 1

100

110 <COMPONENT MOUNTING APPARATUS>

140

<FEEDING DEVICE> 112

111

FEEDER BASE — IF PART

<OVERALL CONTROL DEVICE>

STORAGE PART 141

145

IF PART

INSTALLATION INFORMATION STORAGE AREA 142

APPARATUS INFORMATION STORAGE AREA 143

OVERALL CONTROL PART 144

120

<INSTALLING DEVICE>

121 HEAD

122 BEAM

125

123 SUCTION NOZZLE

IF PART

124 DRIVE CONTROL PART

ARITHMETIC DEVICE 150

INPUT PART 170

130

OUTPUT PART 171

<ABNORMALITY DETECTING DEVICE >

131 ABNORMALITY DETECTION PART

132

IF PART

COMMUNICATION IF PART 172

200 <COMPONENT MOUNTING DEVICE>

173

## FIG. 2

## FIG. 3

# FIG. 4

|  | 142b | 142c | 142a | 142d | 142e |
|---|---|---|---|---|---|
| | ORDER | COMPONENT MOUNTING COORDINATES (X,Y) | SUCTION NOZZLE NO. | FEEDER NO. | ... |
| | 1 | (15. 4, 19. 2) | 1 | 2 | ... |
| | 2 | (13. 2, 11. 4) | 2 | 7 | ... |
| | ... | ... | ... | ... | ... |
| | 105 | (12. 1, 10. 4) | 3 | 7 | ... |

# FIG. 5

| 143b | 143c |
|---|---|
| APPARATUS ID | APPARATUS TYPE |
| 0001 | G1 |

143a

# FIG. 6

**150** <ARITHMETIC DEVICE>

**160** <CONTROL PART>

- ARITHMETIC CONTROL PART — 161
- CAUSE ESTIMATION PART — 162
- LEARNING PROCESSING PART — 163

- INPUT PART — 164
- OUTPUT PART — 165
- IF PART — 166

**151** <STORAGE PART>

- ABNORMALITY HISTORY INFORMATION STORAGE AREA — 152
- APPARATUS OPERATION INFORMATION STORAGE AREA — 153
- ABNORMALITY FREQUENCY INFORMATION STORAGE AREA — 154
- ABNORMALITY FREQUENCY RATIO INFORMATION STORAGE AREA — 155
- FEEDER ABNORMALITY FREQUENCY INFORMATION STORAGE AREA — 156
- COEFFICIENT INFORMATION STORAGE AREA — 157
- ESTIMATED RESULT INFORMATION STORAGE AREA — 158
- LEARNING INFORMATION STORAGE AREA — 159

EP 2 355 646 A2

## FIG. 7

| ID | TIME | SUCTION NOZZLE NO. | FEEDER NO. | VARIABLE 1 | VARIABLE 2 | CAUSE |
|---|---|---|---|---|---|---|
| ... | ... | ... | ... | ... | ... | ... |
| 10 | 04.08.2009  11:52:35 | 2 | 7 | | | |
| 11 | 04.08.2009  11:52:40 | 2 | 7 | 0. 4 | 2 | COMPONENT POSITIONAL DISPLACEMENT |
| ... | ... | ... | ... | ... | ... | ... |
| 21 | 05.08.2009  11:54:30 | 3 | 6 | | | |
| 22 | 05.08.2009  11:55:40 | 3 | 6 | 0. 2 | 2 | COMPONENT POSITIONAL DISPLACEMENT |

## FIG. 8

153a

153b      153c

| SUCTION NOZZLE NO. | FEEDER NO. | | | |
|---|---|---|---|---|
| | 1 | 2 | 3 | ... |
| 1 | 4 | 1 | 0 | ... |
| 2 | 7 | 4 | 4 | ... |
| 3 | 0 | 0 | 3 | ... |
| ... | ... | ... | ... | ... |

153d

## FIG. 9

154a

154b      154c

| SUCTION NOZZLE NO. | FEEDER NO. | | | |
|---|---|---|---|---|
| | 1 | 2 | 3 | ... |
| 1 | 5 | 0 | 0 | ... |
| 2 | 5 | 0 | 0 | ... |
| 3 | 0 | 0 | 1 | ... |
| ... | ... | ... | ... | ... |

154d

## FIG. 10

155a
155b        155c

| SUCTION NOZZLE NO. | FEEDER NO. | | | |
|---|---|---|---|---|
| | 1 | 2 | 3 | ... |
| 1 | 1. 25 | 0 | — | ... |
| 2 | 1. 2 | 0 | 0 | ... |
| 3 | — | — | 0. 25 | ... |
| ... | ... | ... | ... | ... |

155d

## FIG. 11

156a
156b        156c

| FEEDER NO. | ABNORMALITY FREQUENCY |
|---|---|
| 2 | 3 |

## FIG. 12

157a
157b        157c        157d

| MATHEMATICAL EXPRESSION ID | COEFFICIENT a | COEFFICIENT b |
|---|---|---|
| 1 | 1 | 2 |
| 2 | 2 | 3 |

# FIG. 13

158a

158b    158c    158d    158e

| CAUSE CANDIDATE GROUP NAME | CAUSE CANDIDATE GROUP ESTIMATED RESULT | CAUSE CANDIDATE NAME | CAUSE CANDIDATE ESTIMATED RESULT |
|---|---|---|---|
| SUCTION NOZZLE | 0.27 | SUCTION NOZZLE CONTAMINATION | 0.90 |
| | | SUCTION NOZZLE ABRASION | 0.10 |
| FEEDER | 0.73 | COMPONENT POSITIONAL DISPLACEMENT | 0.66 |
| | | DEFECTIVE SUCTION CONFIGURATION | 0.34 |

# FIG. 14

159a

159b    159c

| VARIABLE | CAUSE |
|---|---|
| 0. 2 | 0 |
| 0. 9 | 1 |
| ... | ... |
| 0. 1 | 0 |

# FIG. 15

```
┌─────────────┐
│    START    │
└─────────────┘
       │
       ▼
┌───────────────────────────────┐
│      WRITE ABNORMALITY ID      │ ～S11
└───────────────────────────────┘
       │
       ▼
┌───────────────────────────────────────┐
│  WRITE ABNORMALITY OCCURRENCE TIME     │ ～S12
└───────────────────────────────────────┘
       │
       ▼
┌───────────────────────────────┐
│    WRITE SUCTION NOZZLE NO.    │ ～S13
└───────────────────────────────┘
       │
       ▼
┌───────────────────────────────┐
│       WRITE FEEDER NO.         │ ～S14
└───────────────────────────────┘
       │
       ▼
┌─────────────┐
│     END     │
└─────────────┘
```

# FIG. 16

START

CALCULATE SUCTION FREQUENCY — S21

CALCULATE ABNORMALITY FREQUENCY — S22

CALCULATE ABNORMALITY FREQUENCY RATIO — S23

CALCULATE VARIANCE — S24

ESTIMATE CAUSE OF SUCTION NOZZLE FEEDER — S25

CALCULATE FEEDER ABNORMALITY FREQUENCY — S26

ESTIMATE CAUSES OF COMPONENT POSITIONAL DISPLACEMENT AND DEFECTIVE COMPONENT CONFIGURATION — S27

DISPLAY ESTIMATED RESULT — S28

WRITE CAUSE — S29

END

## FIG. 17

ABNORMALITY OCCURS IN SUCTION NOZZLE NO. 8 AND FEEDER NO. 5.
IT IS ESTIMATED THAT COLORED PART (SHADED PART) CAUSES ABNORMALITY.

| SUCTION NOZZLE | SUCTION NOZZLE CONTAMINATION | ☐ |
| | SUCTION NOZZLE ABRASION | ☐ |
| FEEDER | COMPONENT POSITIONAL DISPLACEMENT | ☑ |
| | DEFECTIVE COMPONENT CONFIGURATION | ☐ |

TICK ADDRESSED CAUSE,
AND PRESS PRODUCTION RESTART

PRODUCTION RESTART

EP 2 355 646 A2

FIG. 18

EP 2 355 646 A2

## FIG. 19

| CAUSE ESTIMATION PART | LEARNING RANGE | LEARNING EXECUTION |
|---|---|---|
| SUCTION NOZZLE/ FEEDER | ☒ ALL APPARATUSES ☐ ONLY THE SAME TYPE ☐ ONLY APPARATUS IN QUESTION | START |
| COMPONENT POSITION/ COMPONENT CONFIGURATION | ☐ ALL APPARATUSES ☐ ONLY THE SAME TYPE ☒ ONLY APPARATUS IN QUESTION | START |

DETERMINE LEARNING CAUSE ESTIMATION PART AND PRESS START

## FIG. 20

*FIG. 21*

**REFERENCES CITED IN THE DESCRIPTION**

**Patent documents cited in the description**

- JP 2005327909 A

- JP 2004144775 A